(19) Europäisches Patentamt
European Patent Office
Office européen des brevets

(11) EP 2 148 393 A1

(12) # EUROPEAN PATENT APPLICATION
published in accordance with Art. 153(4) EPC

(43) Date of publication:
**27.01.2010 Bulletin 2010/04**

(21) Application number: **08752686.9**

(22) Date of filing: **14.05.2008**

(51) Int Cl.:
***H01R 11/01*** *(2006.01)* ***C09J 9/02*** *(2006.01)*
***C09J 201/00*** *(2006.01)* ***H01B 1/00*** *(2006.01)*
***H01B 1/22*** *(2006.01)* ***H01B 5/16*** *(2006.01)*
***H01L 21/60*** *(2006.01)* ***H05K 3/36*** *(2006.01)*

(86) International application number:
**PCT/JP2008/058815**

(87) International publication number:
**WO 2008/140094 (20.11.2008 Gazette 2008/47)**

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **15.05.2007 JP 2007129221**

(71) Applicant: **Hitachi Chemical Company, Ltd.**
**Tokyo 163-0449 (JP)**

(72) Inventors:
- **KOJIMA, Kazuyoshi**
  **Chikusei-shi**
  **Ibaraki 308-8524 (JP)**
- **KOBAYASHI, Kouji**
  **Chikusei-shi**
  **Ibaraki 308-8524 (JP)**
- **ARIFUKU, Motohiro**
  **Chikusei-shi**
  **Ibaraki 308-8524 (JP)**
- **MOCHIZUKI, Nichiomi**
  **Chikusei-shi**
  **Ibaraki 308-8524 (JP)**

(74) Representative: **HOFFMANN EITLE**
**Patent- und Rechtsanwälte**
**Arabellastrasse 4**
**81925 München (DE)**

(54) **CIRCUIT-CONNECTING MATERIAL, AND CONNECTION STRUCTURE FOR CIRCUIT MEMBER**

(57) A circuit-connecting material for electrical connection of two circuit members with circuit electrodes formed thereon, with the circuit electrodes opposing, wherein the circuit-connecting material comprises an adhesive composition and conductive particles, and the conductive particles are conductive particles having a plurality of protrusions on the surface and consisting of a core made of an organic high molecular compound covered with a metal layer composed of nickel or a nickel alloy, the mean particle size of the core being 1-4 μm and the thickness of the metal layer being 65-125 nm.

***Fig.1***

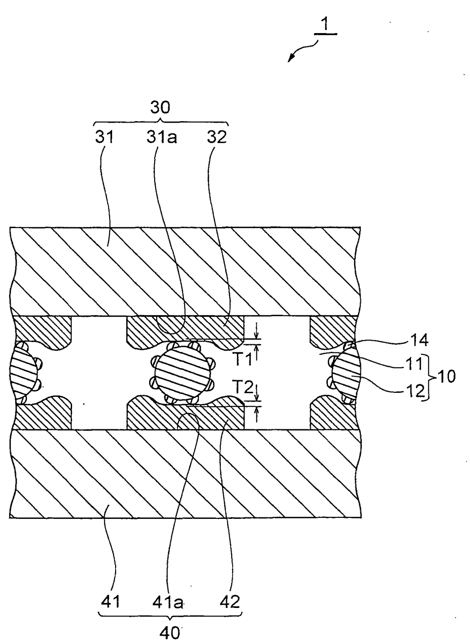


EP 2 148 393 A1

## Description

## Technical Field

The present invention relates to a circuit-connecting material and a circuit member connection structure.

## Background Art

Circuit-connecting materials (for example, "anisotropic conductive adhesives") comprising conductive particles dispersed in an adhesive are used for connection between circuit members, including connection between liquid crystal displays and Tape Carrier Packages (TCP), connection between Flexible Printed Circuits (FPC) and TCPs, and connection between FPCs and printed circuit boards.
Recently, "flip-chip mounting" has been used for mounting of semiconductor silicon chips on boards, wherein semiconductor silicon chips are directly mounted face-down onto boards without using wire bonding for connection between circuit members. Circuit-connecting materials such as anisotropic conductive adhesives are used for connection between circuit members in such flip-chip mounting as well (see Patent documents 1-5).

[Patent document 1] JP S59-120436 A
[Patent document 2] JP S60-191228 A
[Patent document 3] JP H01-251787A
[Patent document 4] JP H07-90237 A
[Patent document 5] JP 2001-189171 A
[Patent document 6] JP 2005-166438 A

## Disclosure of the Invention

### Problems to be Solved by the Invention

Incidentally, the recent trend toward decreasing sizes and thicknesses of electronic devices has led to higher density of circuits formed in circuit members, and extremely narrow spacings between adjacent electrodes and widths of the electrodes themselves. Formation of circuit electrodes is accomplished by a step in which the metal for the circuit is formed over the entire surface of a board, a resist is coated and cured on the sections where the circuit electrodes are to be formed, and the other sections are etched with an acid or base. With the high-density circuits mentioned above, however, the etching time differs between concave portions and convex portions if the irregularities in the metal formed over the entire surface of the board are large, thus making it impossible to accomplish fine etching and leading to problems such as shorting between adjacent circuits, or wire breakage. It is therefore preferred for the electrode surfaces of high-density circuits, i.e. flat electrode surfaces, to have minimal irregularities.
However, when mutually opposing flat circuit electrodes are connected using the conventional circuit-connecting materials mentioned above, the adhesive resin remains between the flat electrodes and the conductive particles that are in the circuit-connecting material, making it impossible to ensure long-term reliability and sufficient electrical connection between the opposing circuit electrodes.
In order to overcome these problems, therefore, there has been proposed connection between opposing circuit electrodes using a circuit-connecting material having conductive particles of gold (Au) in an outermost layer comprising multiple protrusions on the surface side (see Patent document 6).
A circuit connection structure connected using this circuit-connecting material guarantees sufficient electrical connection and long-term reliability between opposing circuit electrodes, but a demand still exists for even more satisfactory electrical connection between opposing circuit electrodes and further increased long-term reliability of electrical characteristics between circuit electrodes.
The present invention has been accomplished in light of these circumstances, and its object is to provide a circuit-connecting material and a circuit member connection structure employing it, that provide satisfactory electrical connection between opposing circuit electrodes as well as sufficiently increased long-term reliability of electrical characteristics between circuit electrodes.

### Means for Solving the Problems

As a result of much diligent research conducted with the aim of solving the aforementioned problems, the present inventors have found that those problems can be attributed particularly to the material of the outermost layer of the conductive particles. Specifically, the outermost layer of the conductive particles in a conventional circuit-connecting

material is a metal film of Au, and because Au is a relatively soft metal, the outermost layer of the conductive particles becomes deformed against the circuit electrodes so that the conductive particles do not readily become embedded in the circuit electrodes even though the adhesive composition between the conductive particles and flat electrodes is penetrated at the protrusions during circuit connection.

The present inventors have further found, as a result of further diligent research toward solving the aforementioned problems, that connection reliability can be improved by changing the material of the outermost layer of the conductive particles to a harder metal than Au, and the invention has been completed upon this finding.

The present invention therefore provides a circuit-connecting material for electrical connection of two circuit members with circuit electrodes formed thereon, with the circuit electrodes opposing, wherein the circuit-connecting material comprises an adhesive composition and conductive particles, and the conductive particles are conductive particles having a plurality of protrusions on the surface and consisting of a core made of an organic high molecular compound covered with a metal layer composed of nickel or a nickel alloy, the mean particle size of the core being 1-4 μm and the thickness of the metal layer being 65-125 nm.

For fabrication of a circuit member connection structure, the circuit-connecting material is situated between two circuit members (hereinafter also referred to as "first and second circuit members") and pressed through the circuit members. With the circuit-connecting material of the invention, it is possible to form more satisfactory electrical connection between opposing circuit electrodes via conductive particles while also further increasing the long-term reliability of electrical characteristics between circuit electrodes, compared to structures wherein the outermost layer of the conductive particles is Au. That is, even though the cured adhesive composition is incorporated between the conductive particles and the circuit electrodes, the multiple protrusions formed on the surface side of the conductive particles causes the pressure applied by the conductive particles onto the cured adhesive composition to be sufficiently larger than conductive particles without protrusions, so that the protrusions of the conductive particles easily penetrate the cured adhesive composition, while they also permeate to some extent in the circuit electrodes, thus increasing the contact area between the conductive particles and circuit electrodes. Moreover, nickel (Ni) or nickel alloys used as the outermost layer of conductive particles are harder than Au, and therefore the outermost layer of the conductive particles permeates more easily into the circuit electrodes, thus allowing the contact area between the conductive particles and circuit electrode to be increased and consequently resulting in more satisfactory long-term reliability of electrical connection and electrical characteristics. Limiting the thickness of the metal layer of the conductive particles to within the range of 65-125 nm stabilizes the connection resistance. In addition, limiting the mean particle size of the core of the conductive particles to within the range of 1-4 μm can minimize the number of conductive particles required for electrical connection, thus helping to adequately maintain an insulating property with adjacent circuits. It is thereby possible to obtain satisfactory electrical connection between circuit electrodes. The satisfactory electrical connection between the opposing circuit electrodes via the conductive particles is also maintained for prolonged periods by the cured adhesive composition, thus allowing sufficient increase in the long-term reliability of the electrical characteristics.

In this circuit-connecting material, the heights of the protrusions of the conductive particles are preferably 50-500 nm. The distance between adjacent protrusions on the conductive particles is preferably no greater than 1000 nm. If the heights of the protrusions of the conductive particles and the distance between adjacent protrusions are within these ranges, it will be possible for the protrusions of the conductive particles to penetrate the cured adhesive composition more easily, so that more satisfactory electrical connection and long-term reliability of electrical characteristics can be obtained.

The invention provides a circuit member connection structure comprising two circuit members having circuit electrodes formed thereon and situated with their circuit electrodes facing each other, and a circuit-connecting member lying between the circuit members and electrically connecting the circuit electrodes, wherein the circuit-connecting member is a circuit-connecting material according to the invention or its cured product.

Since the circuit member connection structure is fabricated using the aforementioned circuit-connecting material, it is possible to obtain satisfactory electrical connection between the circuit electrodes. The satisfactory electrical connection between the opposing circuit electrodes via the conductive particles is also maintained for prolonged periods by the cured adhesive composition, thus allowing sufficient increase in the long-term reliability of the electrical characteristics.

In this circuit member connection structure, at least one of the circuit electrodes of the two circuit members preferably has an outermost layer composed of indium-tin oxide (hereunder, "ITO") or indium-zinc oxide (hereunder, "IZO"). It is advantageous for the circuit electrodes to have an outermost layer composed of ITO or IZO in order to prevent oxidation of the ground layer metal, as compared to electrodes with outermost layers composed of metals such as Au, Ag, Sn or Pt, or Al, Cr or the like.

## Effect of the Invention

The circuit-connecting material of the invention can provide satisfactory electrical connection between opposing

circuit electrodes as well as sufficiently increased long-term reliability of electrical characteristics between circuit electrodes. According to the invention it is also possible to provide a circuit member connection structure with sufficiently high long-term reliability of electrical characteristics between circuit electrodes.

## Brief Description of the Drawings

Fig. 1 is a cross-sectional view showing an embodiment of a circuit member connection structure according to the invention. Fig. 2 is a cross-sectional view showing various forms of conductive particles composing a circuit-connecting material of the invention.

Explanation of Symbols

1: Circuit member connection structure, 10: circuit-connecting member, 11: insulating material, 12: conductive particles, 14: protrusion, 21: core, 21a: nucleus, 21b: protrusion, 22: metal layer, 30: first circuit member, 31: circuit board (first circuit board), 31a: main side, 32: circuit electrode (first circuit electrode), 40: second circuit member, 41: circuit board (second circuit board), 41a: main side, 42: circuit electrode (second circuit electrode), 43: insulating layer (second insulating layer).

## Best Modes for Carrying Out the Invention

Preferred embodiments of the invention will now be explained in detail, with reference to the accompanying drawings as necessary. Through the drawings, corresponding elements will be referred to by like reference numerals and will be explained only once. Unless otherwise specified, the vertical and horizontal positional relationships are based on the positional relationships in the drawings. Also, the dimensional proportions depicted in the drawings are not necessarily limitative.

Fig. 1 is a simplified cross-sectional view showing an example of a circuit member connection structure according to the invention. The circuit member connection structure 1 comprises a first circuit member 30 and a second circuit member 40 which are mutually opposing, and a circuit-connecting member 10 is formed between the first circuit member 30 and second circuit member 40 and connects them. The circuit-connecting member 10 is obtained by curing a circuit-connecting material containing an adhesive composition and conductive particles 12 with multiple protrusions 14 on the surface side. The circuit-connecting member 10 therefore comprises an insulating material 11 and conductive particles 12. The insulating material 11 is composed of a cured adhesive composition.

The first circuit member 30 comprises a circuit board (first circuit board) 31, and a circuit electrode (first circuit electrode) 32 formed on the main side 31a of the circuit board 31. The second circuit member 40 comprises a circuit board 41 and a circuit electrode (first circuit electrode) 42 formed on the main side 41a of the circuit board 41.

The surfaces of the circuit electrodes 32, 42 on the circuit boards 31, 41 are flat. The phrase "the surfaces of the circuit electrodes ... are flat", for the purpose of the invention, means that the sizes of the irregularities on the surfaces of the circuit electrodes are no greater than 20 nm.

The thickness of the circuit electrodes 32, 42 is preferably at least 50 nm. If the thickness of the circuit electrodes 32, 42 is less than 50 nm, the protrusions 14 on the surface sides of the conductive particles 12 in the circuit-connecting material will penetrate the circuit electrodes 32, 42 during contact bonding, potentially contacting the circuit boards 31, 41. This will tend to reduce the contact area between the circuit electrodes 32, 42 and conductive particles 12, thereby increasing the connection resistance. The thickness of the circuit electrodes 32, 42 is preferably no greater than 1000 nm and more preferably no greater than 500 nm, from the viewpoint of production cost.

The material for the circuit electrodes 32, 42 may be an Au, Ag, Sn or Pt-based metal, or indium-tin oxide (ITO), indium-zinc oxide (IZO), Al or Cr. In particular, using ITO or IZO as the material for the circuit electrodes 32, 42 will result in satisfactory electrical connection and a notable effect of the invention. The circuit electrodes 32, 42 may be composed entirely of the aforementioned material, or only the outermost layer alone may be composed of the material.

The material for the circuit boards 31, 41 is not particularly restricted, but will normally be an organic insulating material, glass or silicon.

As specific examples for the first circuit member 30 and second circuit member 40 there may be mentioned chip parts such as semiconductor chips, resistor chips and condenser chips, and boards such as printed boards. The circuit members 30, 40 will normally comprise a plurality of circuit electrodes (circuit terminals) 32, 42 (or one in some cases). The form of the circuit member connection structure may be a connection structure between an IC chip and a chip-mounting board, or a connection structure between electrical circuits.

The first circuit member 30 may be further provided with an insulating layer between the first circuit electrode 32 and circuit board 31, and the second circuit member 40 may be further provided with an insulating layer between the second circuit electrode 42 and circuit board 41. The insulating layers are not particularly restricted so long as they are

composed of insulating materials, but for most purposes they may be made of organic insulating materials, silicon dioxide or silicon nitride.

In the circuit member connection structure 1, the opposing circuit electrode 32 and circuit electrode 42 are electrically connected via a conductive particle 12. That is, the conductive particle 12 directly contacts with both the circuit electrodes 32, 42. Specifically, the protrusions 14 of the conductive particle 12 penetrate the insulating material 11 and contact with the first circuit electrode 32 and second circuit electrode 42.

This adequately reduces the connection resistance between the circuit electrodes 32, 42, allowing satisfactory electrical connection to be established between the circuit electrodes 32, 42. Consequently, smooth current flow can be achieved between the circuit electrodes 32, 42, to allow the function of the circuit to be adequately exhibited.

Some of the protrusions 14 of the conductive particles 12 preferably permeate the circuit electrode 32 or circuit electrode 42. This can further increase the contact area between the circuit electrodes 32, 42 and the protrusions 14 of the conductive particle 12, thus further lowering the connection resistance.

In the circuit member connection structure 1, the surface area of either or both the first circuit electrode 32 and second circuit electrode 42 is preferably no greater than 15,000 $\mu m^2$, and the average number of conductive particles between the first circuit electrode 32 and second circuit electrode 42 is preferably 1 or greater. The average number of conductive particles is the average value for the number of conductive particles per circuit electrode. This restriction allows the connection resistance between the opposing circuit electrodes 32, 42 to be adequately reduced.

An average number of conductive particles of 3 or greater can result in even more satisfactory connection resistance. This is because such a number will lower the connection resistance between the opposing circuit electrodes 32, 42. If the average number of conductive particles between the circuit electrodes 32, 42 is 1 or less, the connection resistance will be too high and the electronic circuits may not function properly.

The circuit-connecting member 10 will now be explained in detail. The circuit-connecting member 10 is in the form of a film and as mentioned above, it is obtained by curing a circuit-connecting material containing an adhesive composition and conductive particles 12 with protrusions 14 on the surface side.

(Conductive particles)

The construction of the conductive particles 12 will be explained first. The conductive particles 12 are composed of particles with a conductive property (particle bodies) and multiple protrusions 14 formed on the surfaces of the particles. The multiple protrusions 14 are composed of a conductive metal. Fig. 2 is a cross-sectional view showing different forms of conductive particles in a circuit-connecting material of the invention.

The conductive particle 12 shown in Fig. 2(a) comprises a core 21 composed of an organic high molecular compound, and a metal layer 22 formed on the surface of the core 21. The core 21 is composed of a nucleus 21 a and protrusions 21 b formed on the surface of the nucleus 21 a. The metal layer 22 has multiple protrusions 14 on the surface side. The metal layer 22 covers the core 21 and protrudes out at locations corresponding to the protrusions 21b, with these protruding sections forming the protrusions 14.

The core 21 is less expensive and has a wider elastic deformation range for dimensional change during thermal expansion and contact bonding compared to metal cores, and is therefore more suitable as a circuit-connecting material.

As examples of organic high molecular compounds for the nucleus 21 a of the core 21, there may be mentioned acrylic resins, styrene resins, benzoguanamine resins, silicone resins, polybutadiene resins, and copolymers of the foregoing, as well as their crosslinked forms.

The mean particle size of the nucleus 21a of the core 21 is preferably 1-4 $\mu$m, more preferably 2-4 $\mu$m and even more preferably 2.5-3.5 $\mu$m. If the mean particle size is less than 1 $\mu$m, secondary aggregation of the particles will tend to occur, resulting in an insufficient insulating property between the adjacent circuits. If the mean particle size is greater than 4 $\mu$m, on the other hand, the area eliminating the adhesive composition during circuit connection will be increased, thus potentially resulting in inadequate insulation with adjacent circuits. The mean particle size of the core 21, for the purpose of the present specification, refers to the mean particle size of the nucleus 21a, and it can be measured using a particle size distribution analyzer, or by observing a cross-section of the conductive particles with an electron microscope.

As examples of organic high molecular compounds to compose the protrusions 21b of the core 21, there may be mentioned acrylic resins, styrene resins, benzoguanamine resins, silicone resins, polybutadiene resins, and copolymers of the foregoing, as well as crosslinked forms thereof. The organic high molecular compound forming the protrusions 21b may be the same as or different from the organic high molecular compound forming the nucleus 21 a.

The core 21 may be formed by adsorbing numerous protrusions 21 b with smaller diameters than the nucleus 21 a onto the surface of the nucleus 21a. The method of adsorbing the protrusions 21b onto the surface of the nucleus 2 1 a may involve, for example, surface-treating one or both particles with a dilute solution of a coupling agent such as silane, aluminum or titanium and an adhesive, and then mixing them to cause their adhesion.

The material for the metal layer 22 is Ni or a Ni alloy, and as examples of Ni alloys there may be mentioned

Ni-B, Ni-W, Ni-B, Ni-W-Co, Ni-Fe and Ni-Cr. Ni is preferred because it is hard and readily permeates into the circuit electrodes 32, 42. The metal layer 22 may be formed by plating such metals onto the core 21 by an electroless plating method. Electroless plating methods are generally categorized as either batch or continuous dropping methods, and the metal layer 22 may be formed by either type.

The thickness of the metal layer 22 (plating thickness) is preferably 65-125 nm, more preferably 75-110 nm and even more preferably 80-100 nm. A metal layer 22 thickness within this range can result in even more satisfactory connection resistance between the circuit electrodes 32, 42. Throughout the present specification, the thickness of the metal layer 22 of the conductive particles refers to the mean thickness at the sections of the metal layer lacking the protrusions 14, and it can be measured for a cross-section of the conductive particles using an electron microscope.

With a metal layer 22 thickness of less than 65 nm, the small thickness of the plating will tend to increase the connection resistance, while a thickness of greater than 125 nm will tend to cause aggregation between conductive particles during plating, resulting in shorting between adjacent circuit electrodes.

The proportion of particles with the metal layer 22 completely separated from the core 21 among the conductive particles 12 is preferably less than 5%, more preferably less than 1.0% and even more preferably less than 0.1%, as determined for 250,000 particles. If the proportion of particles with the metal layer 22 completely separated from the core 21 is within this range, it will be possible to ensure conduction between the circuit electrodes 32, 42. If the proportion of particles with the metal layer 22 completely separated from the core 21 is 5% or greater, the presence of the particles not contributing to conduction on the electrode will tend to increase the connection resistance.

The conductive particles 12 according to the invention may have their cores 21 partially exposed. From the viewpoint of connection reliability, the coverage factor of the metal layer 22 with respect to the surface area of the core 21 is preferably at least 70%, and more preferably 80-100%. A metal layer 22 coverage factor within this range can result in even more satisfactory connection resistance between the circuit electrodes 32, 42. With a metal layer 22 coverage factor of less than 70%, the reduced conduction area on the conductive particle surfaces will tend to result in increased connection resistance.

The heights H of the protrusions 14 of the conductive particles 12 are preferably 50-500 nm, more preferably 65-500 nm and more preferably 100-300 nm. The distance S between adjacent protrusions 14 is preferably no greater than 1000 nm and even more preferably no greater than 500 nm.

The distance S between adjacent protrusions 14 is preferably at least 50 nm, so that the adhesive composition does not permeate between the conductive particles 12 and circuit electrodes 32, 42 and contact is established between the conductive particles 12 and circuit electrodes 32, 42. The heights H of the protrusions 14 of the conductive particles 12 and the distance S between adjacent protrusions 14 can be measured using an electron microscope.

Each conductive particle 12 may have the core 21 composed entirely of the nucleus 21 a, as shown in Fig. 2 (b). In other words, the protrusions 21b on the conductive particle 12 shown in Fig. 2(a) may be absent. The conductive particle 12 shown in Fig. 2(b) can be obtained by metal plating the surface of the core 21a to form a metal layer 22 on the surface of the core 21 a.

A plating method for formation of the protrusions 14 will now be explained. The protrusions 14 may be formed, for example, by adding a plating solution with a higher concentration than the initially used plating solution, during the plating reaction to create a nonuniform plating solution concentration. The pH of the plating solution can also be adjusted, for example to a pH of 6 for a nickel plating solution, to obtain a metal layer 22 with a nodular metal layer, i.e. protrusions 14 (Mochizuki et al., Hyoumen Gijutsu, Vol. 48, No. 4, p.429-432, 1997). A smooth metal layer (coating) can also be obtained when glycine is used as a complexing agent to promote plating bath stability, while a nodular coating, i.e. a metal layer 22 with protrusions 14, can be obtained when tartaric acid or DL-malic acid is used (Ogiwara et al., Amorphous Platings, Vol.36, p.35-37, 1994; Ogiwara et al., Institute of Circuit Mounting, Viol.10, No. 3, p.148-152, 1995).

The metal layer 22 may be composed of a single metal layer or a plurality of metal layers.

(Adhesive composition)

The adhesive composition will now be explained in detail. The adhesive composition has an insulating property and an adhesive property. As adhesive compositions, there are preferred (1) compositions comprising an epoxy resin and a latent curing agent for the epoxy resin, (2) compositions comprising a radical-polymerizing substance and a curing agent that generates free radicals by heat, or mixtures of (1) and (2).

The (1) compositions comprising an epoxy resin and a latent curing agent for the epoxy resin will be explained first. As epoxy resins there may be mentioned bisphenol A-type epoxy resin, bisphenol F-type epoxy resin, bisphenol S-type epoxy resin, phenol-novolac-type epoxy resin, cresol-novolac-type epoxy resin, bisphenol A/novolac-type epoxy resin, bisphenol F/novolac-type epoxy resin, alicyclic epoxy resin, glycidyl ester-type epoxy resin, glycidylamine-type epoxy resin, hydantoin-type epoxy resin, isocyanurate-type epoxy resin and aliphatic straight-chain epoxy resins. These epoxy resins may be halogenated or hydrogenated These epoxy resins may also be used in combinations of two or more.

The latent curing agent may be any one that can cure the epoxy resin. As latent curing agents there may be

mentioned anionic polymerizable catalyst-type curing agents, cationic polymerizable catalyst-type curing agents and polyaddition-type curing agents. Any of these may be used alone or in mixtures of two or more. Preferred among these are anionic and cationic polymerizable catalyst-type curing agents since they have excellent fast-curing properties and do not require special consideration in regard to chemical equivalents.

As anionic or cationic polymerizable catalyst-type curing agents there may be mentioned imidazole-based compounds, hydrazide-based compounds, boron trifluoride-amine complexes, sulfonium salts, amineimides, diaminomaleonitrile, melamine and its derivatives, polyamine salts and dicyandiamides, as well as modified forms of the foregoing. As polyaddition-type curing agents there may be mentioned polyamines, polymercaptanes, polyphenols and acid anhydrides.

When a tertiary amine or imidazole is added as an anionic polymerizable catalyst-type curing agent, the epoxy resin is cured by heating at a moderate temperature of about 160°C-200°C for between several tens of seconds and several hours. This is preferred because it lengthens the usable time (pot life).

Preferred examples of cationic polymerizable catalyst-type curing agents include photosensitive onium salts (mainly aromatic diazonium salts, aromatic sulfonium salts and the like) that cure epoxy resins under energy ray exposure.

Aliphatic sulfonium salts are among those that are activated by heat instead of energy ray exposure and cure epoxy resins. Such curing agents are preferred because of their fast-curing properties.

Microencapsulated forms obtained by covering these latent curing agents with polyurethane-based or polyester-based polymer substances or inorganic materials such as metal thin-films of nickel or copper, or calcium silicate, are preferred as they can lengthen the pot life.

The (2) composition comprising a radical-polymerizing substance and a curing agent which generates free radicals in response to heating will now be described.

The radical-polymerizing substance is a substance having functional groups that polymerize by radicals. As such radical-polymerizing substances there may be mentioned acrylate (including corresponding methacrylate, same hereunder) compounds, acryloxy (including corresponding methacryloxy, same hereunder) compounds, maleimide compounds, citraconimide resins and nadimide resins. The radical-polymerizing substance may be used as a monomer or oligomer, or a monomer and oligomer may be used in combination.

As specific examples of acrylate compounds there may be mentioned methyl acrylate, ethyl acrylate, isopropyl acrylate, isobutyl acrylate, ethyleneglycol diacrylate, diethyleneglycol diacrylate, trimethylolpropane triacrylate, tetramethylolmethane tetraacrylate, 2-hydroxy-1,3-diacryloxypropane, 2,2-bis[4-(acryloxymethoxy)phenyl]propane, 2,2-bis [4-(acryloxypolyethoxy)phenyl]propane, dicyclopentenyl acrylate, tricyclodecanyl acrylate, tris(acryloyloxyethyl) isocyanurate and urethane acrylate. Any of these may be used alone or in mixtures of two or more.

If necessary, an appropriate amount of a polymerization inhibitor such as hydroquinone or methyl ether hydroquinone may be used. From the viewpoint of improving the heat resistance, the acrylate compound preferably has at least one substituent selected from the group consisting of dicyclopentenyl, tricyclodecanyl and triazine rings.

The maleimide compound preferably has two or more maleimide groups in the molecule. As examples of such maleimide compounds there may be mentioned 1-methyl-2,4-bismaleimidebenzene, N,N'-m-phenylenebismaleimide, N,N'-p-phenylenebismaleimide, N,N'-m-toluilenebismaleimide, N,N'-4,4-biphenylenebismaleimide, N,N'-4,4-(3,3'-dimethylbiphenylene)bismaleimide, N,N'-4,4-(3,3'-dimethyldiphenylmethane)bismaleimide, N,N'-4,4-(3,3'-diethyldiphenylmethane)bismaleimide, N,N'-4,4-diphenylmethanebismaleimide, N,N'-4,4-diphenylpropanebismaleimide, N,N'-3,3'-diphenylsulfonebismaleimide, N,N-4,4-diphenyl etherbismaleimide, 2,2-bis(4-(4-maleimidephenoxy)phenyl)propane, 2,2-bis(3-s-butyl-4,8-(4-maleimidephenoxy)phenyl)propane, 1,1-bis(4-(4-maleimidephenoxy)phenyl)decane, 4,4'-cyclohexylidene-bis(1-(4-maleimidephenoxy)-2-cyclohexylbenzene and 2,2-bis(4-(4-maleimidephenoxy)phenyl)hexafluoropropane. Any of these may likewise be used alone or in mixtures of two or more.

The citraconimide resin is a compound obtained by polymerizing a citraconimide compound with at least one citraconimide group in the molecule. As examples of citraconimide compounds there may be mentioned phenylcitraconimide, 1-methyl-2,4-biscitraconimidebenzene, N,N-m-phenylenebiscitraconimide, N,N'-p-phenylenebiscitraconimide, N,N'-4,4-biphenylenebiscitraconimide, N,N'-4,4-(3,3-dimethylbiphenylene)biscitraconimide, N,N'-4,4-(3,3-dimethyldiphenylmethane)biscitraconimide, N,N'-4,4-(3,3-diethyldiphenylmethane)biscitraconimide, N,N'-4,4-diphenylmethanebiscitraconimide, N,N'-4,4-diphenylpropanebiscitraconimide, N,N'-4,4-diphenyl etherbiscitraconimide, N,N'-4,4-diphenylsulfonebiscitraconimide, 2,2-bis(4-(4-citraconimidephenoxy)phenyl)propane, 2,2-bis(3-s-butyl-3,4-(4-citraconimidephenoxy)phenyl)propane, 1,1 1-bis(4-(4-citraconimidephenoxy)phenyl)decane, 4,4'-cyclohexylidene-bis(1-(4-citraconimidephenoxy)phenoxy)-2-cyclohexylbenzene and 2,2-bis(4-(4-citraconimidephenoxy)phenyl)hexafluoropropane. Any of these may likewise be used alone or in mixtures of two or more.

The nadimide resin is a compound obtained by polymerizing a nadimide compound with at least one nadimide group in the molecule. As examples of nadimide compounds there may be mentioned phenylnadimide, 1-methyl-2,4-bisnadimidebenzene, N,N-m-phenylenebisnadimide, N,N'-p-phenylenebisnadimide, N,N'-4,4-biphenylenebisnadimide, N,N'-4,4-(3,3-dimethylbiphenylene)bisnadimide, N,N'-4,4-(3,3-dimethyldiphenylmethane)bisnadimide, N,N'-4,4-(3,3-diethyldiphenylmethane)bisnadimide, N,N'-4,4-diphenylmethanebisnadimide, N,N'-4,4-diphenylpropanebisnadimide, N,N'-4,4-diphenyl etherbisnadimide, N,N'-4,4-diphenylsulfonebisnadimide, 2,2-bis(4-(4-nadimidephenoxy)phenyl)propane, 2,2-bis(3-s-butyl-3,4-(4-nadimidephenoxy)phenyl)propane, 1,1-bits(4-(4-nadimidephenoxy)phenyl)decane, 4,4'-cyclohexylidene-bis(1-(4-nadimidephenoxy)phenoxy)-2-cyclohexylbenzene and 2,2-bis(4-(4-nadimidephenoxy)phenyl) hexafluoropropane. Any of these may likewise be used alone or in mixtures of two or more.

A radical-polymerizing substance having a phosphoric acid ester structure represented by the following chemical formula (I) is preferably used together with the aforementioned radical-polymerizing substance. This will improve the adhesive strength with respect to inorganic material surfaces such as metals, thus rendering the circuit suitable for bonding between circuit electrodes.

[Chemical Formula 1]

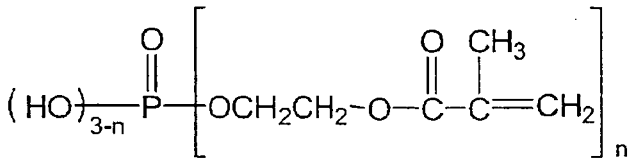

· · · (I)

In the formula, n represents an integer of 1-3.

The radical-polymerizing substance with a phosphoric acid ester structure is obtained by reaction between phosphoric anhydride and 2-hydroxyethyl (meth)acrylate. As radical-polymerizing substances with phosphoric acid ester structures there may be mentioned, specifically, mono(2-methacryloyloxyethyl)-acid phosphate and di(2-methacryloyloxyethyl)acid phosphate. Any of these may likewise be used alone or in mixtures of two or more.

The content of the radical-polymerizing substance with a phosphoric acid ester structure represented by chemical formula (I) above is preferably 0.01-50 parts by weight and more preferably 0.5-5 parts by weight with respect to 100 parts by weight as the total of the radical-polymerizing substance and the film-forming material that is added as necessary.

The radical-polymerizing substance may be used together with allyl acrylate. In such cases, the allyl acrylate content is preferably 0.1-10 parts by weight and more preferably 0.5-5 parts by weight with respect to 100 parts by weight as the total of the radical-polymerizing substance and the film-forming material that is added as necessary.

The curing agent which generates free radicals upon heating is a curing agent that generates free radicals by decomposition upon heating. As such curing agents there may be mentioned peroxide compounds and azo-based compounds. Such curing agents may be appropriately selected as appropriate for the desired connection temperature, connection time and pot life. From the standpoint of achieving both high reactivity and a long pot life, an organic peroxide with a 10 hour half-life temperature of 40°C or higher and a 1 minute half-life temperature of no higher than 180°C is preferred, and an organic peroxide with a 10 hour half-life temperature of 60°C or higher and a 1 minute half-life temperature of no higher than 170°C is more preferred.

For a connection time of up to 25 seconds, the curing agent content is approximately 2-10 parts by weight and more preferably 4-8 parts by weight with respect to 100 parts by weight as the total of the radical-polymerizing substance and the film-forming material which is added as necessary, in order to obtain a sufficient reaction rate. If no limit on the connection time can be assumed, the curing agent content is preferably 0.05-20 parts by weight and more preferably 0.1-10 parts by weight with respect to 100 parts by weight as the total of the radical-polymerizing substance and the film-forming material which is added as necessary.

As curing agents that generate free radicals by heating there may be mentioned, specifically, diacyl peroxides, peroxy dicarbonates, peroxy esters, peroxy ketals, dialkyl peroxides, hydroperoxides and silyl peroxides.

From the viewpoint of inhibiting corrosion of the circuit electrodes 32, 42 the curing agent preferably has a chloride ion or organic acid concentration of no greater than 5000 ppm, and more preferably the content of organic acids generated after thermal decomposition is low.

As such curing agents there may be mentioned, specifically, peroxy esters, dialkyl peroxides, hydroperoxides and silyl peroxides, and the curing agent is preferably selected from among peroxy esters that exhibit high reactivity. These curing agents may also be used in appropriate mixtures.

As peroxy esters there may be mentioned cumylperoxy neodecanoate, 1,1,3,3-tetramethylbutylperoxy neodecanoate, 1-cyclohexyl-1-methylethylperoxy neodecanoate, t-hexylperoxy neodecanoate, t-butylperoxy pivalate, 1,1,3,3-tetramethylbutylperoxy2-ethyl hexanonate, 2,5-dimethyl-2,5-di(2-ethylhexanoylperoxy)hexane, 1-cyclohexyl-1-methylethylperoxy-2-ethyl hexanonate, t-hexylperoxy-2-ethyl hexanonate, t-butylperoxy-2-ethyl hexanonate, t-butylperoxy isobutyrate, 1,1-bis(t-butylperoxy)cyclohexane, t-hexylperoxyisopropyl monocarbonate, t-butylperoxy-3,5,5-trimethyl hexanonate, t-butylperoxy laurate, 2,5-dimethyl-2,5-di(m-toluoylperoxy)hexane, t-butylperoxyisopropyl monocarbonate, t-butylperoxy-2-ethylhexyl monocarbonate, t-hexylperoxybenzoate and t-butylperoxy acetate.

As dialkyl peroxides there may be mentioned $\alpha,\alpha'$-bis(t-butylperoxy)diisopropylbenzene, dicumyl peroxide, 2,5-dimethyl-2,5-di(t-butylperoxy)hexane and t-butylcumyl peroxide.

As hydroperoxides there may be mentioned diisopropylbenzene hydroperoxide and cumene hydroperoxide.

As diacyl peroxides there may be mentioned isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide.

As peroxy dicarbonates there may be mentioned di-n-propylperoxy dicarbonate, diisopropylperoxy dicarbonate, bis(4-t-butylcyclohexyl)peroxy dicarbonate, di-2-ethoxymethoxyperoxy dicarbonate, di(2-ethylhexylperoxy)dicarbonate, dimethoxybutylperoxy dicarbonate and di(3-methyl-3-methoxybutylperoxy)dicarbonate.

As peroxy ketals there may be mentioned 1,1-bis(t-hexylperoxy)-3,3,5-trimethylcyclohexane, 1,1 -bis(t-hexylperoxy)cyclohexane, 1,1-bis(t-butylperoxy)-3,3,5-trimethylcyclohexane, 1,1-(t-butylperoxy)cyclododecane and 2,2-bis (t-butylperoxy)decane.

As silyl peroxides there may be mentioned t-butyltrimethylsilyl peroxide, bis(t-butyl)dimethylsilyl peroxide, t-butyltrivinylsilyl peroxide, bis(t-butyl)divinylsilyl peroxide, tris(t-butyl)vinylsilyl peroxide, t-butyltriallylsilyl peroxide, bis(t-butyl)diallylsilyl peroxide and tris(t-butyl)allylsilyl peroxide.

These curing agents may be used alone or in combinations of two or more, and may also be used in admixture with resolution accelerators or inhibitors. These curing agents are preferably used in microencapsulated form by coating with a polyurethane-based or polyester-based macromolecular compound. Microencapsulated curing agents are preferred for a longer pot life.

The adhesive composition may also contain an added film-forming material if necessary. A film-forming material is a material which, when a liquid substance is solidified as a structural composition and formed into a film, facilitates handling of the film and confers mechanical properties that prevent tearing, cracking or sticking, thereby permitting it to be handled as a film under ordinary conditions (ordinary temperature and pressure).

As film-forming materials there may be mentioned phenoxy resins, polyvinyl formal resins, polystyrene resins, polyvinyl butyral resins, polyester resins, polyamide resins, xylene resins and polyurethane resins. Phenoxy resins are preferred among these because of their excellent adhesion, compatibility, heat resistance and mechanical strength.

A phenoxy resin is a resin obtained either by reacting a bifunctional phenol with an epihalohydrin until polymerization, or by polyaddition of a bifunctional epoxy resin and a bifunctional phenol. The phenoxy resin may be obtained by, for example, reacting 1 mol of a bifunctional phenol with 0.985-1.015 mol of an epihalohydrin in a nonreactive solvent at a temperature of 40-120°C, in the presence of a catalyst such as an alkali metal hydroxide.

From the viewpoint of resin mechanical properties and thermal properties, particularly preferred phenoxy resins are those obtained by polyaddition reaction of a bifunctional epoxy resin and a bifunctional phenol at an epoxy group/phenol hydroxyl group equivalent ratio of 1/0.9-1/1.1, with heating to 50-200°C under conditions with a reaction solid content of no greater than 50 parts by weight, in an amide-based, ether-based, ketone-based, lactone-based or alcohol-based organic solvent with a boiling point of 120°C or higher, in the presence of a catalyst such as an alkali metal compound, organic phosphorus-based compound and cyclic amine-based compound.

As bifunctional epoxy resins there may be mentioned bisphenol A-type epoxy resins, bisphenol F-type epoxy resins, bisphenol AD-type epoxy resins, bisphenol S-type epoxy resins, biphenyldiglycidyl ethers and methyl-substituted biphenyldiglycidyl ethers.

Bifunctional phenols have two phenolic hydroxyl groups. As examples of bifunctional phenols there may be mentioned hydroquinones, and bisphenols such as bisphenol A, bisphenol F, bisphenol AD, bisphenol S, bisphenolfluorene, methyl-substituted bisphenolfluorene, dihydroxybiphenyl and methyl-substituted dihydroxybiphenyl.

The phenoxy resin may be modified with radical-polymerizing functional groups or with other reactive compounds (for example, it may be epoxy-modified). A phenoxy resin may be used alone, or two or more different ones may be used in combination.

The adhesive composition may also contain a polymer or copolymer comprising at least one from among acrylic acid, acrylic acid esters, methacrylic acid esters and acrylonitrile as a monomer component. It is preferred to also use a copolymer-based acrylic rubber containing glycidyl acrylate or glycidyl methacrylate with a glycidyl ether group, for excellent stress relaxation. The weight-average molecular weight of the acrylic rubber is preferably at least 200,000 from the viewpoint of increasing the cohesion of the adhesive.

The content of the conductive particles 12 is preferably 0.1-30 parts by volume with respect to 100 parts by volume of the adhesive composition, and the content may be selected depending on the purpose of use. From the viewpoint of preventing shorting between the circuit electrodes by excess conductive particles 12, the content of the conductive particles 12 is more preferably 0.1-10 parts by volume.

The circuit-connecting material may also contain rubber fine particles, a filler, softening agent, accelerator, antioxidant, coloring agent, flame retardant, thixotropic agent, coupling agent, phenol resin, melamine resin or isocyanate.

The rubber fme particles may have a mean particle size of up to twice the mean particle size of the conductive

particles 12, and they may have a storage elastic modulus of up to 1/2 the storage elastic modulus of the conductive particles 12 and adhesive composition at room temperature. Fine particles wherein the material of the rubber fine particles is silicone, an acrylic emulsion, SBR, NBR or polybutadiene rubber are particularly suitable, either alone or in combinations of two or more types. Three-dimensionally crosslinked rubber fine particles have excellent solvent resistance and readily disperse in the adhesive composition.

A filler is preferably included in the circuit-connecting material to improve the connection reliability. The filler used may be any one with a maximum size that is up to 1/2 the mean particle size of the conductive particles 12. A filler particle size that is larger than the conductive particles may interfere with flattening of the conductive particles. If non-conductive particles are used in combination therewith, any filler with a size of no greater than the size of the non-conductive particles may be used.

The content of the filler is preferably 5-60 parts by volume with respect to 100 parts by volume of the adhesive composition. If the content is greater than 60 parts by volume, the effect of improved connection reliability will tend to be saturated, while if it is less than 5 parts by volume the effect of addition of the filler will tend to be insufficiently exhibited.

Preferred coupling agents, from the viewpoint of improving adhesion, are compounds containing vinyl groups, acrylic groups, epoxy groups or isocyanate groups.

A film-like circuit-connecting material may be formed by coating a support (a PET (polyethylene terephthalate) film or the like) with the circuit-connecting material using a coating apparatus (not shown), and drying it with hot air for a prescribed time period.

[Process for production of circuit member connection structure]

A process for producing the circuit member connection structure 1 described above will now be explained.

First, there are prepared a first circuit member 30 with a first circuit electrode 32, a second circuit member 40 with a second circuit electrode 42, and a circuit-connecting material. The circuit-connecting material may be, for example, a circuit-connecting material shaped into a film (hereinafter referred to as "circuit-connecting material film"). The circuit-connecting material film comprises the aforementioned adhesive composition and conductive particles 12. The thickness of the circuit-connecting material film is preferably 10-50 μm.

The circuit-connecting material film is then placed over the first circuit member 30. The second circuit member 40 is placed on the circuit-connecting material film with the first circuit electrode 32 and second circuit electrode 42 facing each other. This situates the circuit-connecting material film between the first circuit member 30 and second circuit member 40. The circuit-connecting material film is easy to manage since it is in the form of a film. Thus, the circuit-connecting material film can be easily situated between the first circuit member 30 and second circuit member 40 when they are connected, thus facilitating the connection operation for the first circuit member 30 and second circuit member 40.

Next, the circuit-connecting material film is heated and pressed through the first circuit member 30 and second circuit member 40 for curing treatment to form a circuit-connecting member 10 between the first and second circuit members 30, 40. The curing treatment may be carried out by an ordinary method, which may be appropriately selected depending on the adhesive composition. When the outermost layer of the conductive particles 12 in the circuit-connecting material is Ni, the protrusions 14 will permeate deeper into the first or second circuit electrodes 32, 42 than conductive particles with Au as the outermost layer, since Ni is harder than Au, and therefore the contact area between the conductive particles 12 and circuit electrodes 32, 42 will be increased. Limiting the thickness of the metal layer of the conductive particles to within the range of 65-125 nm stabilizes the connection resistance. Curing treatment of the circuit-connecting material results in curing of the adhesive composition, with high adhesive strength between the first circuit member 30 and second circuit member 40, so that firm contact between the conductive particles 12 and the first and second circuit electrodes 32, 42 can be maintained for prolonged periods.

It is thus possible to sufficiently lower connection resistance between the opposing first and second circuit electrodes 32, 42 regardless of whether or not irregularities are present on the surface of the first and/or second circuit electrode 32, 42, in order to achieve satisfactory electrical connection between the first circuit electrode 32 and second circuit electrode 42 while adequately increasing the long-term reliability of electrical characteristics between the first and second circuit electrodes 32, 42.

Incidentally, although the circuit member connection structure 1 of this embodiment is fabricated using a circuit-connecting material film, a circuit-connecting material that is not in the form of a film may be used instead of a circuit-connecting material film. In this case as well, dissolving the circuit-connecting material in a solvent and coating and drying the solution on either or both the first circuit member 30 and second circuit member 40 allows it to be situated between the first and second circuit members 30, 40.

The present invention is not in any way limited to the preferred embodiment described above.

Examples

The present invention will now be explained in detail by examples, with the understanding that the invention is not limited to the examples.

Preparation of conductive particles]

(Fabrication of cores)

[Cores with a mean particle size of 3 μm were obtained by suspension polymerization with different mixing ratios of tetramethylolmethane tetraacrylate, divinylbenzene and styrene monomer, using benzoyl peroxide as the polymerization initiator, and classifying the obtained polymer.

(Formation of conductive particles No. 1)

The surfaces of the cores were subjected to electroless Ni plating treatment to obtain conductive particles No. 1 having a Ni layer (metal layer) with a uniform thickness of 100 nm.

(Formation of conductive particles No. 2)

The conductive particles No. 1 were subjected to substitution plating with Au to a thickness of 25 nm, forming an Au layer with a uniform thickness to obtain conductive particles No. 2.

(Formation of conductive particles No. 3)

The charging mass of the plating solution and the treatment temperature and time for electroless Ni plating treatment on the core surface were adjusted to vary the plating thickness, to form Ni plating protrusions on the core surface. Conductive particles No. 3 having a Ni layer target thickness of 40-60 nm were formed.

(Formation of conductive particles No. 4)

The charging mass of the plating solution and the treatment temperature and time for electroless Ni plating treatment on the core surface were adjusted to vary the plating thickness, to form Ni plating protrusions on the core surface. Conductive particles No. 4 having a Ni layer target thickness of 60-80 nm were formed.

(Formation of conductive particles No. 5)

The charging mass of the plating solution and the treatment temperature and time for electroless Ni plating treatment on the core surface were adjusted to vary the plating thickness, to form Ni plating protrusions on the core surface. Conductive particles No. 5 having a Ni layer target thickness of 90-100 nm were formed.

(Formation of conductive particles No. 6)

The charging mass of the plating solution and the treatment temperature and time for electroless Ni plating treatment on the core surface were adjusted to vary the plating thickness, to form Ni plating protrusions on the core surface. Conductive particles No. 6 having a Ni layer target thickness of 110-130 nm were formed.

(Formation of conductive particles No. 7)

The charging mass of the plating solution and the treatment temperature and time for electroless Ni plating treatment on the core surface were adjusted to vary the plating thickness, to form Ni plating protrusions on the core surface. Conductive particles No. 7 having a Ni layer target thickness of 130-150 nm were formed.

(Formation of conductive particles No. 8)

The conductive particles No. 5 were subjected to substitution plating with Au to a thickness of 25 nm, forming an Au layer with multiple protrusions to obtain conductive particles No. 8.
The conductive particles No. 1-8 formed in this manner were observed with an electron microscope (S-800 by

Hitachi, Ltd.), and the thickness of the metal layer, the heights of the protrusions and the distance between adjacent protrusions were measured. The results are shown in Table 1.

[Table 1]

| Conductive particles | Metal layer | | Protrusion height (nm) | Distance between protrusions (nm) | Other |
|---|---|---|---|---|---|
| | Type | Thickness (nm) | | | |
| No. 1 | Ni | 100 | No protrusions | No protrusions | - |
| No. 2 | Au/Ni | 25/100 | No protrusions | No protrusions | - |
| No. 3 | Ni | 50 | 85 | 1000 | - |
| No. 4 | Ni | 65 | 100 | 700 | - |
| No. 5 | Ni | 100 | 130 | 500 | - |
| No. 6 | Ni | 125 | 155 | 400 | Particle aggregation: minimal |
| No. 7 | Ni | 150 | 180 | 300 | Particle aggregation: notable |
| No. 8 | Au/Ni | 25/100 | 155 | 500 | - |

(Preparation of phenoxy resin)

There was dissolved 50 g of a phenoxy resin (trade name: PKHC, product of Union Carbide Corp., weight-average molecular weight: 45,000) in a mixed solvent of toluene/ethyl acetate = 50/50 (weight ratio) to prepare a phenoxy resin solution with a solid content of 40 wt%.

(Synthesis of urethane acrylate)

With this solution there were combined 400 parts by weight of polycaprolactonediol (weight-average molecular weight: 800), 131 parts by weight of 2-hydroxypropyl acrylate, 0.5 part by weight of dibutyltin dilaurate as a catalyst and 1.0 part by weight of hydroquinonemonomethyl ether as a polymerization inhibitor, while stirring and heating at 50°C. Next, 222 parts by weight of isophorone diisocyanate was added dropwise to the mixture and the temperature was raised to 80°C while stirring for urethanation reaction. Upon confirming at least a 99% isocyanate group reaction rate, the reaction temperature was lowered to obtain urethane acrylate.

[Fabrication of circuit-connecting material]

(Fabrication of circuit-connecting material A)

An adhesive composition was obtained by mixing 125 g of the phenoxy resin solution (solid weight: 50 g), 49 g of urethane acrylate, 1 g of a phosphoric acid ester-type acrylate and 5 g of t-hexylperoxy-2-ethyl hexanonate as a curing agent that generates free radicals by heat. In 100 parts by weight of the obtained adhesive composition there was dispersed 2.3 parts by weight of conductive particles No. 4 to prepare a circuit-connecting material.

A coating apparatus was used to coat the circuit-connecting material onto a 50 μm-thick PET film surface-treated on one side, and the coating was dried with hot air at 70°C for 3 minutes to form a circuit-connecting material film A to a thickness of 18 μm on the PET film.

(Fabrication of circuit-connecting material B)

A circuit-connecting material film B with a thickness of 18 μm was fabricated in the same manner as the circuit-connecting material A, except that 3.0 parts by weight of conductive particles No. 5 was used instead of the conductive particles No. 4.

(Fabrication of circuit-connecting material C)

A circuit-connecting material film C with a thickness of 18 μm was fabricated in the same manner as the circuit-connecting material A, except that 3.6 parts by weight of conductive particles No. 6 was used instead of the conductive particles No. 4.

(Fabrication of circuit-connecting material D)

A circuit-connecting material film D with a thickness of 18 μm was fabricated in the same manner as the circuit-connecting material A, except that 1.8 parts by weight of conductive particles No. 3 was used instead of the conductive particles No. 4.

(Fabrication of circuit-connecting material E)

A circuit-connecting material film E with a thickness of 18 μm was fabricated in the same manner as the circuit-connecting material A, except that 4.0 parts by weight of conductive particles No. 7 was used instead of the conductive particles No. 4.

(Fabrication of circuit-connecting material F)

A circuit-connecting material film F with a thickness of 18 μm was fabricated in the same manner as the circuit-connecting material A, except that 3.0 parts by weight of conductive particles No. 1 was used instead of the conductive particles No. 4.

(Fabrication of circuit-connecting material G)

A circuit-connecting material film G with a thickness of 18 μm was fabricated in the same manner as the circuit-connecting material A, except that 3.0 parts by weight of conductive particles No. 2 was used instead of the conductive particles No. 4.

(Fabrication of circuit-connecting material H)

A circuit-connecting material film H with a thickness of 18 μm was fabricated in the same manner as the circuit-connecting material A, except that 3.0 parts by weight of conductive particles No. 8 was used instead of the conductive particles No. 4.

[Fabrication of circuit member connection structure]

(Example 1)

A flexible circuit board (hereinafter, FPC) was prepared having a two-layer structure composed of a polyimide film (thickness: 38 μm) and a Sn-plated Cu foil (thickness: 8 μm), as a first circuit member. The circuit of the FPC had a line width of 18 μm and a pitch of 50 μm.

Next, a glass substrate (thickness: 1.1 mm) was prepared comprising an ITO circuit electrode (thickness: 50 nm, surface resistance: <20 Ω) on the surface, as a second circuit member. The circuit of the second circuit member had a line width of 25 μm and a pitch of 50 μm.

Circuit-connecting material A cut to a prescribed size (1.5 × 30 mm) was attached onto the second circuit member, and connection was established by heating and pressing at 70°C, 1.0 MPa for 3 seconds. The PET film was then released, the FPC was positioned so that the circuit-connecting material A was sandwiched by the FPC and second circuit member, and the circuit of the FPC and the circuit of the second circuit member were aligned. This was heated and pressed from above the FPC under conditions of 170°C, 3 MPa, 10 seconds for main connection between the FPC and second circuit member. The circuit member connection structure was fabricated in this manner.

(Example 2)

An FPC was prepared in the same manner as Example 1 as the first circuit member. Next, a glass substrate (thickness: 1.1 mm) was prepared comprising an IZO circuit electrode (thickness: 50 nm, surface resistance: <20 Ω) on the surface, as a second circuit member. The circuit of the second circuit member had a line width of 25 μm and a pitch

of 50 μm. The circuit-connecting material A was used to fabricate a circuit member connection structure in the same manner as Example 1.

(Example 3)

An FPC was prepared in the same manner as Example 1 as the first circuit member. Next, a glass substrate (thickness: 1.1 mm) was prepared comprising a circuit electrode with an ITO (outermost layer, thickness: 50 nm)/Cr (thickness: 200 nm) bilayer structure (surface resistance: <20 Ω) on the surface, as a second circuit member. The circuit of the second circuit member had a line width of 25 μm and a pitch of 50 μm. The circuit-connecting material A was used to fabricate a circuit member connection structure in the same manner as Example 1.

(Example 4)

An FPC was prepared in the same manner as Example 1 as the first circuit member. Next, a glass substrate (thickness: 1.1 mm) was prepared comprising a circuit electrode with an ITO (outermost layer, thickness: 50 nm)/Ti (thickness: 100 nm)/Al (thickness: 200 nm)/Ti (thickness: 100 nm) four-layer structure (surface resistance: <20 Ω) on the surface, as a second circuit member. The circuit of the second circuit member had a line width of 25 μm and a pitch of 50 μm. The circuit-connecting material A was used to fabricate a circuit member connection structure in the same manner as Example 1.

(Example 5)

An FPC was prepared in the same manner as Example 1 as the first circuit member. Next, a glass substrate (thickness: 1.1 mm) was prepared comprising an Al circuit electrode (thickness: 200 nm, surface resistance: <5 Ω) on the surface, as a second circuit member. The circuit of the second circuit member had a line width of 25 μm and a pitch of 50 μm. The circuit-connecting material A was used to fabricate a circuit member connection structure in the same manner as Example 1.

(Example 6)

A circuit member connection structure was fabricated in the same manner as Example 1, except for using the circuit-connecting material B instead of the circuit-connecting material A.

(Example 7)

A circuit member connection structure was fabricated in the same manner as Example 2, except for using the circuit-connecting material B instead of the circuit-connecting material A.

(Example 8)

A circuit member connection structure was fabricated in the same manner as Example 3, except for using the circuit-connecting material B instead of the circuit-connecting material A.

(Example 9)

A circuit member connection structure was fabricated in the same manner as Example 4, except for using the circuit-connecting material B instead of the circuit-connecting material A.

(Example 10)

A circuit member connection structure was fabricated in the same manner as Example 5, except for using the circuit-connecting material B instead of the circuit-connecting material A.

(Example 11)

A circuit member connection structure was fabricated in the same manner as Example 1, except for using the circuit-connecting material C instead of the circuit-connecting material A.

(Example 12)

A circuit member connection structure was fabricated in the same manner as Example 2, except for using the circuit-connecting material C instead of the circuit-connecting material A.

(Example 13)

A circuit member connection structure was fabricated in the same manner as Example 3, except for using the circuit-connecting material C instead of the circuit-connecting material A.

(Example 14)

A circuit member connection structure was fabricated in the same manner as Example 4, except for using the circuit-connecting material C instead of the circuit-connecting material A.

(Example 15)

A circuit member connection structure was fabricated in the same manner as Example 5, except for using the circuit-connecting material C instead of the circuit-connecting material A.

(Comparative Example 1)

A circuit member connection structure was fabricated in the same manner as Example 1, except for using the circuit-connecting material D instead of the circuit-connecting material A.

(Comparative Example 2)

A circuit member connection structure was fabricated in the same manner as Example 2, except for using the circuit-connecting material D instead of the circuit-connecting material A.

(Comparative Example 3)

A circuit member connection structure was fabricated in the same manner as Example 3, except for using the circuit-connecting material D instead of the circuit-connecting material A.

(Comparative Example 4)

A circuit member connection structure was fabricated in the same manner as Example 4, except for using the circuit-connecting material D instead of the circuit-connecting material A.

(Comparative Example 5)

A circuit member connection structure was fabricated in the same manner as Example 5, except for using the circuit-connecting material D instead of the circuit-connecting material A.

(Comparative Example 6)

A circuit member connection structure was fabricated in the same manner as Example 1, except for using the circuit-connecting material E instead of the circuit-connecting material A.

(Comparative Example 7)

A circuit member connection structure was fabricated in the same manner as Example 2, except for using the circuit-connecting material E instead of the circuit-connecting material A.

(Comparative Example 8)

A circuit member connection structure was fabricated in the same manner as Example 3, except for using the

circuit-connecting material E instead of the circuit-connecting material A.

(Comparative Example 9)

A circuit member connection structure was fabricated in the same manner as Example 4, except for using the circuit-connecting material E instead of the circuit-connecting material A.

(Comparative Example 10)

A circuit member connection structure was fabricated in the same manner as Example 5, except for using the circuit-connecting material E instead of the circuit-connecting material A.

(Comparative Example 11)

A circuit member connection structure was fabricated in the same manner as Example 1, except for using the circuit-connecting material F instead of the circuit-connecting material A.

(Comparative Example 12)

A circuit member connection structure was fabricated in the same manner as Example 2, except for using the circuit-connecting material F instead of the circuit-connecting material A.

(Comparative Example 13)

A circuit member connection structure was fabricated in the same manner as Example 3, except for using the circuit-connecting material F instead of the circuit-connecting material A.

(Comparative Example 14)

A circuit member connection structure was fabricated in the same manner as Example 4, except for using the circuit-connecting material F instead of the circuit-connecting material A.

(Comparative Example 15)

A circuit member connection structure was fabricated in the same manner as Example 5, except for using the circuit-connecting material F instead of the circuit-connecting material A.

(Comparative Example 16)

A circuit member connection structure was fabricated in the same manner as Example 1, except for using the circuit-connecting material G instead of the circuit-connecting material A.

(Comparative Example 17)

A circuit member connection structure was fabricated in the same manner as Example 2, except for using the circuit-connecting material G instead of the circuit-connecting material A.

(Comparative Example 18)

A circuit member connection structure was fabricated in the same manner as Example 3, except for using the circuit-connecting material G instead of the circuit-connecting material A.

(Comparative Example 19)

A circuit member connection structure was fabricated in the same manner as Example 4, except for using the circuit-connecting material G instead of the circuit-connecting material A.

(Comparative Example 20)

A circuit member connection structure was fabricated in the same manner as Example 5, except for using the circuit-connecting material G instead of the circuit-connecting material A.

(Comparative Example 21)

A circuit member connection structure was fabricated in the same manner as Example 1, except for using the circuit-connecting material H instead of the circuit-connecting material A.

(Comparative Example 22)

A circuit member connection structure was fabricated in the same manner as Example 2, except for using the circuit-connecting material H instead of the circuit-connecting material A.

(Comparative Example 23)

A circuit member connection structure was fabricated in the same manner as Example 3, except for using the circuit-connecting material H instead of the circuit-connecting material A.

(Comparative Example 24)

A circuit member connection structure was fabricated in the same manner as Example 4, except for using the circuit-connecting material H instead of the circuit-connecting material A.

(Comparative Example 25)

A circuit member connection structure was fabricated in the same manner as Example 5, except for using the circuit-connecting material H instead of the circuit-connecting material A.

[Number of conductive particles on circuit electrode]

A differential interference microscope was used for visual count of the number of conductive particles on each circuit electrode of the circuit member connection structure (n = 38). As a result, the average number of conductive particles on the circuit electrodes of Examples 1-15 and Comparative Examples 1-25 was in the range of 32-45, and no major change in the number of conductive particles was found with different circuit-connecting materials or circuit members.

[Measurement of connection resistance]

A multimeter (trade name: "Digital Multimeter 7461A" by ADC) was used to measure the connection resistance value between the first circuit member (FPC) circuit electrode and the second circuit member circuit electrode in the circuit member connection structure. The connection resistance values were measured initially (immediately after connection) and after standing for 500 hours in a thermo-hygrostat at 80°C, 95% RH (high-temperature, high-humidity treatment). The results are shown in Table 2.

In Table 2, the connection resistance values are expressed as the sum of the average value and three times the standard deviation (x+3σ) for 37 resistance points between the adjacent circuits. The increase in resistance is expressed as the percentage increase of the resistance value after high-temperature, high-humidity treatment from the initial resistance value, and specifically it was calculated by the following formula:

$$\text{Increase in resistance (\%)} = [(\text{resistance value after treatment} - \text{initial resistance value})/\text{initial resistance value})] \times 100.$$

The improving effect on connection reliability was judged as follows: less than 10% increase in resistance was judged as an improving effect, at least 10% and less than 20% was judged as prior art level, and 20% or greater was judged

as no improving effect (NG).

[Table 2]

| | Circuit-connecting material | Conductive particles | | | Second circuit electrode | Connection resistance (Ω) | | Resistance increase (%) |
|---|---|---|---|---|---|---|---|---|
| | | No. | Protrusions | Outermost layer (thickness) | | Initial | Post-treatment | |
| Example 1 | A | 4 | Yes | Ni (65 μm) | ITO circuit | 117.3 | 124.7 | 6.3 |
| Example 2 | | | | | IZO circuit | 85.6 | 91.2 | 6.5 |
| Example 3 | | | | | ITO/Cr circuit | 67.3 | 72.3 | 7.4 |
| Example 4 | | | | | ITO/Ti/Al/Ti circuit | 68.5 | 73.6 | 7.4 |
| Example 5 | | | | | Al circuit | 22.5 | 23.1 | 2.7 |
| Example 6 | B | 5 | Yes | Ni (100 μm) | ITO circuit | 121.6 | 128.3 | 5.5 |
| Example 7 | | | | | IZO circuit | 88.4 | 93.6 | 5.9 |
| Example 8 | | | | | ITO/Cr circuit | 66.5 | 70.5 | 6.0 |
| Example 9 | | | | | ITO/Ti/Al/Ti circuit | 67.8 | 72.0 | 6.2 |
| Example 10 | | | | | Al circuit | 23.3 | 24.1 | 3.4 |
| Example 11 | C | 6 | Yes | Ni (125pm) | ITO circuit | 121.6 | 130.4 | 7.2 |
| Example 12 | | | | | IZO circuit | 88.4 | 95.4 | 7.9 |
| Example 13 | | | | | ITO/Cr circuit | 66.5 | 72.2 | 8.6 |
| Example 14 | | | | | ITO/Ti/Al/Ti circuit | 68.7 | 72.9 | 7.5 |
| Example 15 | | | | | Al circuit | 22.4 | 22.9 | 2.2 |

(continued)

| | Circuit-connecting material | Conductive particles | | | Second circuit electrode | Connection resistance (Ω) | | Resistance increase (%) |
|---|---|---|---|---|---|---|---|---|
| | | No. | Protrusions | Outermost layer (thickness) | | Initial | Post-treatment | |
| Comp. Ex. 1 | D | 3 | Yes | Ni (50 μm) | ITO circuit | 128.4 | 174.8 | 36.1 |
| Comp. Ex. 2 | | | | | IZO circuit | 90.1 | 127.7 | 41.7 |
| Comp. Ex. 3 | | | | | ITO/Cr circuit | 71.3 | 98.6 | 38.3 |
| Comp. Ex. 4 | | | | | ITO/Ti/Al/Ti circuit | 72.1 | 104.7 | 45.2 |
| Comp. Ex. 5 | | | | | Al circuit | 26.5 | 34.7 | 30.9 |
| Comp. Ex. 6 | E | 7 | Yes | Ni (150 μm) | ITO circuit | 121.6 | 134.4 | 10.5 |
| Comp. Ex. 7 | | | | | IZO circuit | 88.4 | 98.3 | 11.2 |
| Comp. Ex. 8 | | | | | ITO/Cr circuit | 66.5 | 73.5 | 10.5 |
| Comp. Ex. 9 | | | | | ITO/Ti/Al/Ti circuit | 67.8 | 74.6 | 10.0 |
| Comp. Ex. 10 | | | | | Al circuit | 22.4 | 24.0 | 7.1 |
| Comp. Ex. 11 | F | 1 | No | Ni (100 μm) | ITO circuit | 126.3 | 163.4 | 29.4 |
| Comp. Ex. 12 | | | | | IZO circuit | 92.6 | 117.2 | 26.6 |
| Comp. Ex. 13 | | | | | ITO/Cr circuit | 68.4 | 94.7 | 38.5 |
| Comp. Ex. 14 | | | | | ITO/Ti/Al/Ti circuit | 71.1 | 96.0 | 35.0 |
| Comp. Ex. 15 | | | | | Al circuit | 26.0 | 34.9 | 34.2 |
| Comp. Ex. 16 | G | 2 | No | Au (25 μm) | ITO circuit | 116.4 | 140.8 | 21.0 |
| Comp. Ex. 17 | | | | | IZO circuit | 86.2 | 103.3 | 19.8 |
| Comp. Ex. 18 | | | | | ITO/Cr circuit | 66.7 | 83.4 | 25.0 |
| Comp. Ex. 19 | | | | | ITO/Ti/Al/Ti circuit | 66.8 | 81.1 | 21.4 |
| Comp. Ex. 20 | | | | | Al circuit | 23.9 | 27.5 | 15.1 |

(continued)

| | Circuit-connecting material | Conductive particles | | | Second circuit electrode | Connection resistance (Ω) | | Resistance increase (%) |
|---|---|---|---|---|---|---|---|---|
| | | No. | Protrusions | Outermost layer (thickness) | | Initial | Post-treatment | |
| Comp. Ex. 21 | H | 8 | Yes | Au (25 μm) | ITO circuit | 118.7 | 135.2 | 13.9 |
| Comp. Ex. 22 | | | | | IZO circuit | 85.8 | 99.4 | 15.9 |
| Comp. Ex. 23 | | | | | ITO/Cr circuit | 70.4 | 82.2 | 16.8 |
| Comp. Ex. 24 | | | | | ITO/Ti/Al/Ti circuit | 65.5 | 77.3 | 18.0 |
| Comp. Ex. 25 | | | | | Al circuit | 22.4 | 23.2 | 3.6 |

As shown in Table 2, when the second circuit member wherein the entire circuit electrode or the outermost layer thereof was composed of ITO or IZO was used, the effect was extremely small, with an increase in resistance of less than 10%, in the circuit member connection structures of Examples 1-4, 6-9 and 11-14. In contrast, the increase in resistance was approximately 10-18% in the circuit member connection structures of Comparative Examples 6-9 and 21-24, while the increase in resistance was 20% or greater in the circuit member connection structures of Comparative Examples 1-4, 11-14 and 16-19.

This demonstrated that improved connection reliability is obtained when connection is established using a circuit-connecting material comprising conductive particles having protrusions and an outermost layer of Ni with a thickness of 65-125 nm, in a circuit electrode wherein the entire circuit electrode or the outermost layer is composed of ITO or IZO.

In addition, when the second circuit member comprising an Al circuit electrode was used, the increase in resistance was small at less than 10% in Examples 5, 10 and 15 and Comparative Example 10, wherein connection was established with a circuit-connecting material comprising conductive particles having protrusions and an outermost layer of Ni with a thickness of 65 nm or greater. This result was attributed to penetration of the oxide film of the Al circuit electrode surface by the protrusions on the conductive particle surfaces, and its contact with the circuit electrode, during connection. In contrast, the increase in resistance was approximately 15-34% in Comparative Examples 15 and 20, wherein connection was established with a circuit-connecting material containing conductive particles without protrusions. The increase in resistance was approximately 30% in Comparative Example 5, wherein connection was established with a circuit-connecting material comprising conductive particles having protrusions and an outermost layer of Ni with a thickness of 50 nm.

Since the increase in resistance was comparable in Examples 5, 10 and 15 and Comparative Example 10, which employed conductive particles having protrusions and an outermost layer of Ni, and Comparative Example 25 which employed conductive particles having protrusions and an outermost layer of Au, the effect on improved connection reliability based on differences in the metal of the outermost layer of the conductive particles tends to be less notable for a circuit member wherein the circuit electrode is composed of Al.

The results described above confirmed that the circuit-connecting material of the invention can provide satisfactory electrical connection between opposing circuit electrodes, while also sufficiently increasing stable connection reliability in high-temperature, high-humidity environments and in thermal shock tests.

## Industrial Applicability

The circuit-connecting material of the invention can provide satisfactory electrical connection between opposing circuit electrodes as well as sufficiently increased long-term reliability of electrical characteristics between circuit electrodes. According to the invention it is also possible to provide a circuit member connection structure with sufficiently high long-term reliability of electrical characteristics between circuit electrodes.

## Claims

1. A circuit-connecting material for electrical connection of two circuit members with circuit electrodes formed thereon, with the circuit electrodes opposing, wherein
the circuit-connecting material comprises an adhesive composition and conductive particles, and
the conductive particles are conductive particles having a plurality of protrusions on the surface and consisting of a core made of an organic high molecular compound covered with a metal layer composed of nickel or a nickel alloy, the mean particle size of the core being 1-4 μm and the thickness of the metal layer being 65-125 nm.

2. The circuit-connecting material according to claim 1, wherein the heights of the protrusions are 50-500 nm.

3. The circuit-connecting material according to claim 1 or 2, wherein the distance between adjacent protrusions is no greater than 1000 nm.

4. A circuit member connection structure comprising
two circuit members having circuit electrodes formed thereon and situated with their circuit electrodes facing each other, and
a circuit-connecting member lying between the circuit members and electrically connecting the circuit electrodes, wherein the circuit-connecting member is a circuit-connecting material according to any one of claims 1 to 3 or its cured product.

5. The circuit member connection structure according to claim 4, wherein at least one of the two circuit member circuit electrodes has an outermost layer composed of indium-tin oxide.

6. The circuit member connection structure according to claim 4,
wherein at least one of the two circuit member circuit electrodes has an outermost layer composed of indium-zinc oxide.

*Fig.1*

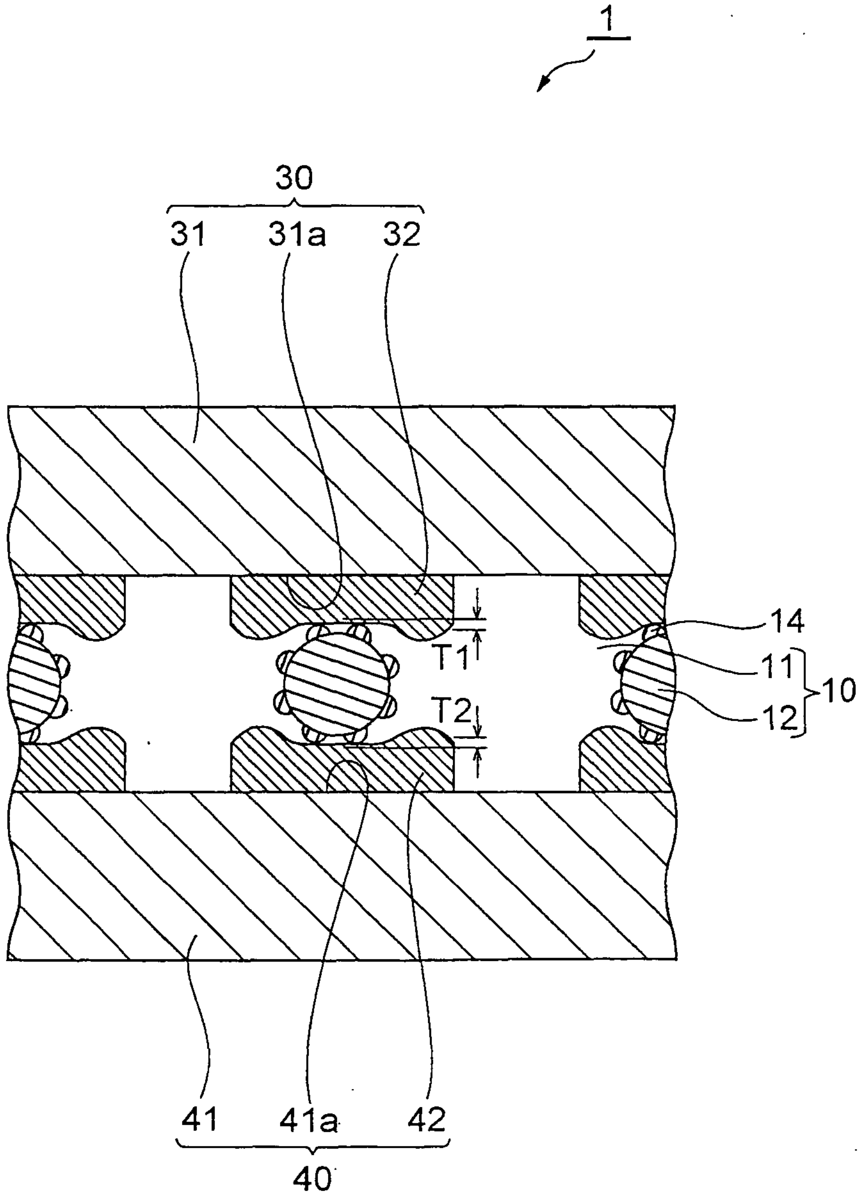

*Fig.2*

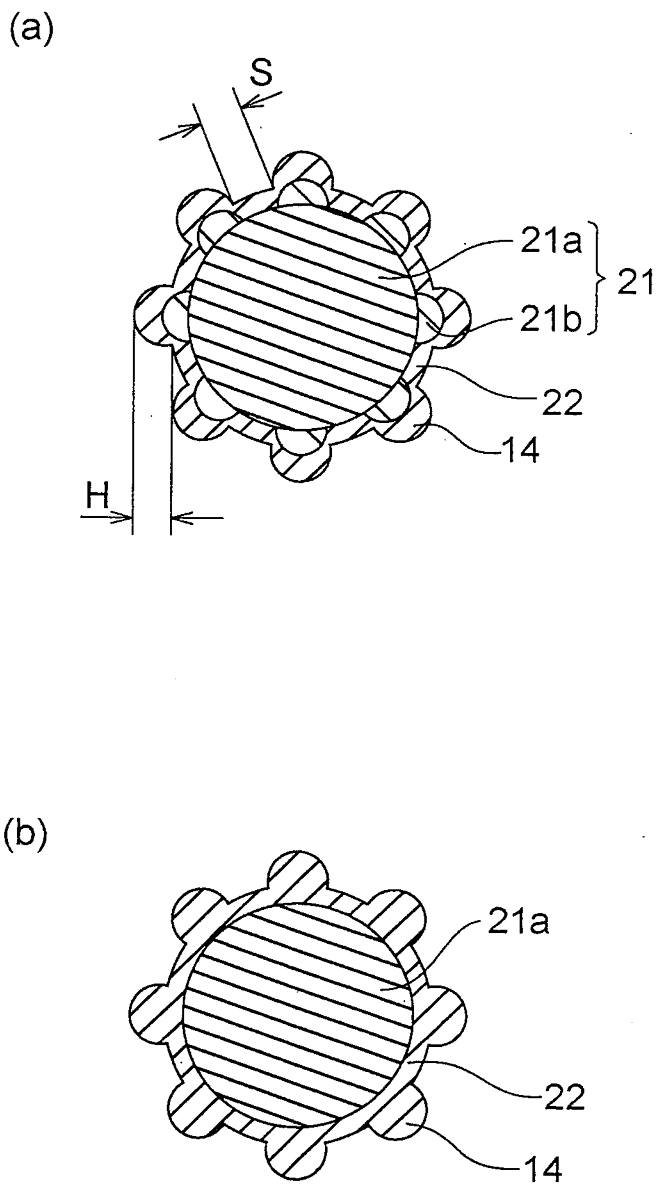

**INTERNATIONAL SEARCH REPORT**

International application No.
PCT/JP2008/058815

A. CLASSIFICATION OF SUBJECT MATTER
*H01R11/01*(2006.01)i, *C09J9/02*(2006.01)i, *C09J201/00*(2006.01)i, *H01B1/00*(2006.01)i, *H01B1/22*(2006.01)i, *H01B5/16*(2006.01)i, *H01L21/60*(2006.01)i, *H05K3/36*(2006.01)i
According to International Patent Classification (IPC) or to both national classification and IPC

B. FIELDS SEARCHED

Minimum documentation searched (classification system followed by classification symbols)
H01R11/01, C09J9/02, C09J201/00, H01B1/00, H01B1/22, H01B5/16, H01L21/60, H05K3/36

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2008 |
| Kokai Jitsuyo Shinan Koho | 1971-2008 | Toroku Jitsuyo Shinan Koho | 1994-2008 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 2005-166438 A (Hitachi Chemical Co., Ltd.), 23 June, 2005 (23.06.05), Full text; all drawings (Family: none) | 1-6 |
| Y | JP 2000-243132 A (The Nippon Chemical Industrial Co., Ltd.), 08 September, 2000 (08.09.00), Full text; all drawings & US 6770369 B1 | 1-6 |
| A | JP 2006-228474 A (Sekisui Chemical Co., Ltd.), 31 August, 2006 (31.08.06), Full text; all drawings (Family: none) | 1-4 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 30 May, 2008 (30.05.08) | 10 June, 2008 (10.06.08) |

| Name and mailing address of the ISA/ | Authorized officer |
|---|---|
| Japanese Patent Office | |
| Facsimile No. | Telephone No. |

Form PCT/ISA/210 (second sheet) (April 2007)

**INTERNATIONAL SEARCH REPORT**

International application No.
PCT/JP2008/058815

C (Continuation). DOCUMENTS CONSIDERED TO BE RELEVANT

| Category* | Citation of document, with indication, where appropriate, of the relevant passages | Relevant to claim No. |
|---|---|---|
| A | WO 2005/073985 A1 (Sekisui Chemical Co., Ltd.), 11 August, 2005 (11.08.05), Full text; all drawings & US 2007/0092698 A1 | 1-4 |

Form PCT/ISA/210 (continuation of second sheet) (April 2007)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 59120436 A
- JP 60191228 A
- JP H01251787 A
- JP H0790237 A
- JP 2001189171 A
- JP 2005166438 A


### Non-patent literature cited in the description


- **Mochizuki et al.** *Hyoumen Gijutsu,* 1997, vol. 48 (4), 429-432
- **Ogiwara et al.** *Amorphous Platings,* 1994, vol. 36, 35-37
- **Ogiwara et al.** *Institute of Circuit Mounting,* 1995, vol. 10 (3), 148-152